# EUROPEAN PATENT APPLICATION

(11) **EP 4 610 586 A1**
(43) Date of publication of application: **03.09.2025**
(21) Application number: 25158492.6
(22) Date of filing: 18.02.2025
(51) Int. Cl.: F28D 15/04

(54) **HEAT PIPE**

(30) Priority: 01.03.2024 CN 202410240817
(71) Applicant: Purple Cloud Development Pte. Ltd., Singapore 128424 (SG)
(72) Inventor: LIU, LEI LEI, Hui Zhou City (CN); HSIEH, CHENG-HAN, Taipei City (TW); HUANG, JIAN-JIA, Taipei City (TW)
(74) Representative: Grünecker Patent- und Rechtsanwälte PartG mbB

(57) **Abstract**

A heat pipe includes a pipe body having an evaporation section, a condensation section, and a transmission section, the evaporation section and the condensation section are respectively connected to opposite ends of the transmission section, and a composite capillary structure including a first capillary structure and at least one second capillary structure, the first capillary structure having a grooved shape and being disposed on an inner surface of the pipe body, the second capillary structure being at least partially disposed on the first capillary structure, the first capillary structure and the at least one second capillary structure extending from the evaporation section to the condensation section, wherein the composite capillary structure has a variable thickness within the evaporation section.

## Description

### TECHNICAL FIELD

The present utility model relates to a heat pipe, particularly for heat pipe with a capillary structure having a variable thickness.

### BACKGROUND

Electronic devices or machines generate heat with a high temperature during operation, and manufacturers often install heat pipes to dissipate the heat. The heat pipes achieve rapid temperature uniformity by utilizing the internal cooling fluid's evaporation and condensation.

In detail, after the liquid cooling fluid in the heat pipe absorbs heat at the evaporation end, the liquid cooling fluid vaporizes and moves to the condensation end by vapor pressure. After the gaseous cooling fluid at the condensation end is exothermic and condensed into liquid cooling fluid, the liquid cooling fluid flows back to the evaporation end through capillary structures inside the heat pipe, and then absorbs heat again and evaporates, so as to carry out the cooling cycle. However, the cooling cycle of the cooling fluid through the capillary structure within conventional heat pipes remains inefficient. Consequently, one of the issues that R&D personnel should address is how to enhance the heat pipe's heat dissipation efficacy for electronic devices or machinery during operation.

### SUMMARY

The invention is as defined in the appended claims. Aspects of the disclosure provide a heat pipe including a pipe body having an evaporation section, a condensation section, and a transmission section, the evaporation section and the condensation section are respectively connected to opposite ends of the transmission section, and a composite capillary structure including a first capillary structure and at least one second capillary structure, the first capillary structure having a grooved shape and being disposed on an inner surface of the pipe body, the second capillary structure being at least partially disposed on the first capillary structure, the first capillary structure and the second capillary structure extending from the evaporation section to the condensation section, wherein the composite capillary structure has a variable thickness within the evaporation section.

In an embodiment, a thickness of the first capillary structure within the evaporation section can be gradually increased from one end away from the condensation section to one end close to the condensation section, so that the variable thickness of the composite capillary structure varies within the evaporation section.

In an embodiment, the first capillary structure within the evaporation section can have a length greater than or equal to 10 mm and smaller than or equal to 200 mm.

In an embodiment, the thickness of the first capillary structure within the evaporation section and at one end close to the condensation section can be greater than or equal to 0.1 mm and smaller than or equal to 1 mm.

In an embodiment, the thickness of the first capillary structure within the evaporation section and at one end close to the condensation section can be greater than or equal to 0.1 mm and smaller than or equal to 0.5 mm.

In an embodiment, the first capillary structure within the evaporation section can have a slope surface, where an angle between the slope surface and the inner surface of the pipe body can be greater than or equal to 0.1 degree and smaller than or equal to 6.5 degree.

In an embodiment, the angle between the slope surface and the inner surface of the pipe body can be greater than or equal to 0.1 degree and smaller than or equal to 3.5 degree.

In an embodiment, the first capillary structure within the evaporation section can have a plurality of spacers disposed on the inner surface of the pipe body, the at least one second capillary structure within the evaporation section is disposed on the plurality of spacers and the pipe body so that the variable thickness of the composite capillary structure within the evaporation section has intermittent changes.

In an embodiment, the at least one second capillary structure disposed on the plurality of spacers can have a first thickness and the at least one second capillary structure disposed on the pipe body has a second thickness, where the first thickness is smaller than the second thickness.

In an embodiment, the first capillary structure can have a thickness that is greater than or equal to 0.01 mm and smaller than or equal to 1 mm.

In an embodiment, the thickness of the first capillary structure can be greater than or equal to 0.01 mm and smaller than or equal to 0.7 mm.

In an embodiment, the first thickness or the second thickness of the at least one second capillary structure can be greater than or equal to 0.3 mm and smaller than or equal to 10 mm.

In an embodiment, a ratio between a total length of the plurality of spacers and a total length of gaps between two adjacent spacers can be great than or equal to 1/10 and smaller than or equal to 1. For example, the ratio between the total length of the plurality of spacers and the total length of gaps between two adjacent spacers can be 1/3.

In an embodiment, a ratio between a total length of the plurality of spacers and a total length of gaps between two adjacent spacers can be great than or equal to 1 and smaller than or equal to 10.

In an embodiment, the at least one second capillary structure can be metal powder, metal braided mesh, or a combination thereof.

In an embodiment, the at least one second capillary structure within the evaporation section can have a variable thickness.

### BRIEF DESCRIPTION OF DRAWINGS

Aspects of the present disclosure can be understood from the following detailed description when read with the accompanying figures. It is noted that, in accordance with the standard practice in the industry, various features are not drawn to scale. In fact, the dimensions of the various features may be increased or reduced for clarity of discussion.
Fig. 1 illustrates a perspective view of a heat pipe 10 according to aspects of the present disclosure.
Fig. 2 illustrates a cross-sectional view of the heat pipe 10 as shown in Fig. 1.
Fig. 3 illustrates a partially enlarged cross-sectional view of the heat pipe 10 as shown in Fig. 1.
Fig. 4 illustrates a cross-sectional view of the heat pipe 10 along the A-A cutline in Fig. 3.
Fig. 5 illustrates a cross-sectional view of the heat pipe 10 along the B-B cutline in Fig. 3.
Fig. 6 illustrates a cross-sectional view of a heat pipe 10A according to aspects of the present disclosure.
Fig. 7 illustrates a partially enlarged cross-sectional view of the heat pipe 10A as shown in Fig. 6.
Fig. 8 illustrates a cross-sectional view of the heat pipe 10A along the C-C cutline in Fig. 7.
Fig. 9 illustrates a cross-sectional view of the heat pipe 10A along the D-D cutline in Fig. 7.

### DETAILED DESCRIPTION

Detailed descriptions and technical contents of the present invention are illustrated below in conjunction with the accompanying drawings. However, it is to be understood that the descriptions and the accompanying drawings disclosed herein are merely illustrative and exemplary and not intended to limit the scope of the present invention.

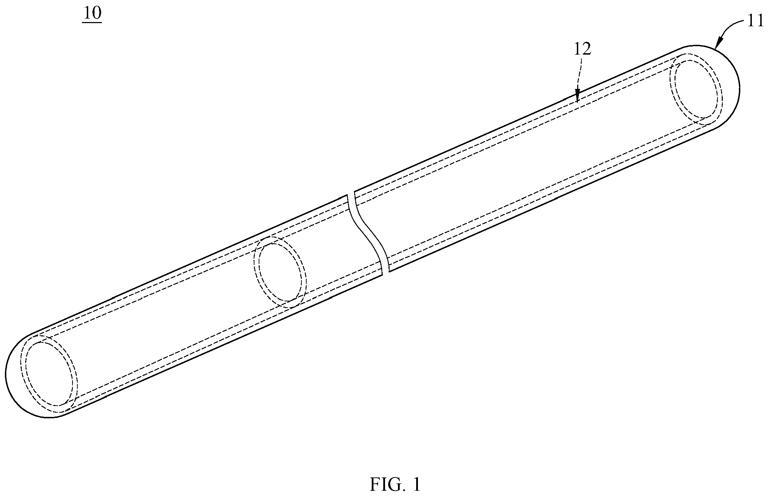

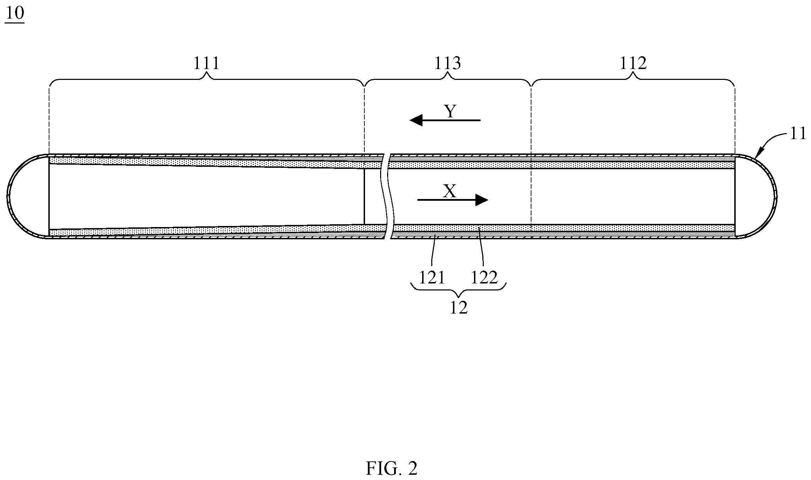

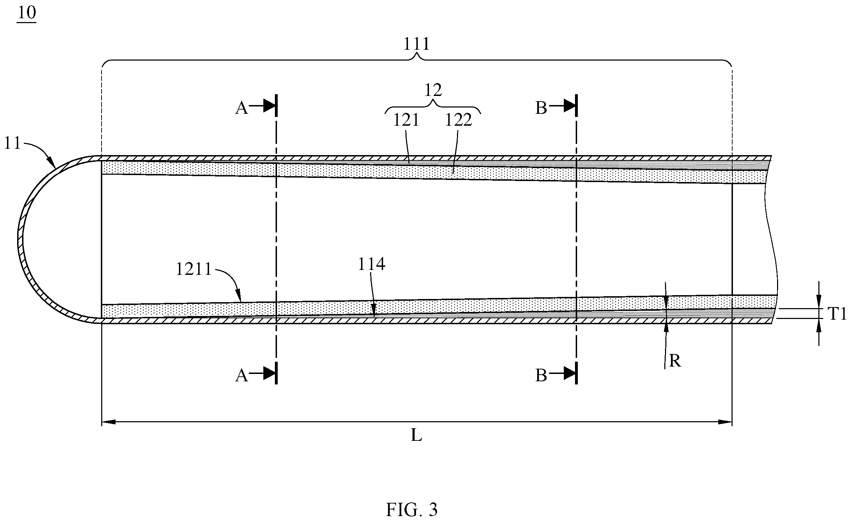

Please refer to Fig. 1 to Fig. 3. Fig. 1 illustrates a perspective view of a heat pipe 10 according to aspects of the present disclosure. Fig. 2 illustrates a cross-sectional view of the heat pipe 10 as shown in Fig. 1. Fig. 3 illustrates a partially enlarged cross-sectional view of the heat pipe 10 as shown in Fig. 1.

The heat pipe 10 can be used to accommodate a cooling fluid (not shown), for example, water, refrigerant, or alcohol such as methanol or ethanol. The heat pipe 10 includes a pipe body 11 and a composite capillary structure 12. The pipe body 11 include an evaporation section 111, a condensation section 112, and a transmission section 113. The evaporation section 111 and the condensation section 112 are respectively connected to opposite ends of the transmission section 113. The evaporation section 111 can be used to thermally coupled to a heat source (not shown), such as a central processing unit (CPU) or graphics processing unit (GPU), to absorb the heat generated by the heat source. The "thermally coupled" is referring to either directly thermal contact or connection, or indirectly thermal contact or connection through other thermally conductive media.

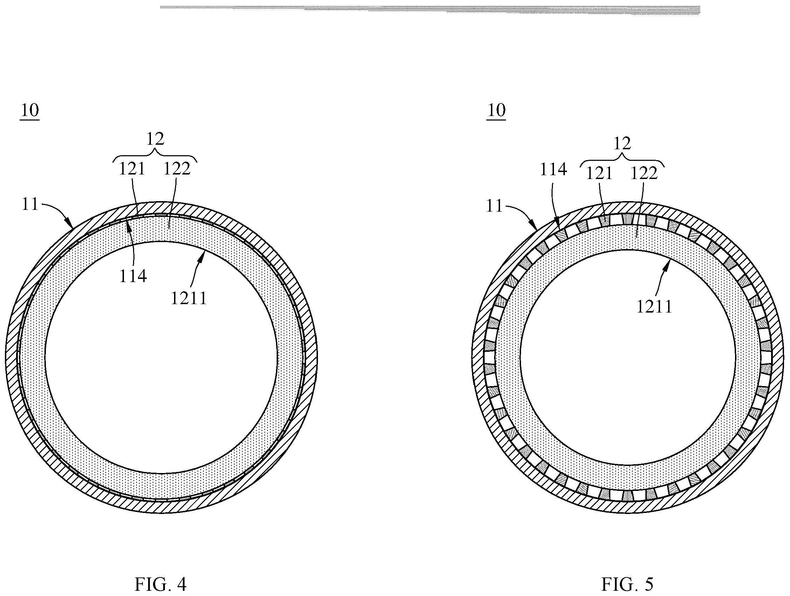

Please also refer to Fig. 4 and Fig. 5. Fig. 4 illustrates a cross-sectional view of the heat pipe 10 along the A-A cutline in Fig. 3. Fig. 5 illustrates a cross-sectional view of the heat pipe 10 along the B-B cutline in Fig. 3.

The composite capillary structure 12 includes a first capillary structure 121 and a second capillary structure 122. The first capillary structure 121 has a grooved shape and disposed on an inner surface 114 of the pipe body 11. The first capillary structure 121 can be intergraded with the pipe body 11. The second capillary structure 122 can be disposed on the first capillary structure 121. The second capillary structure 122 can be formed using, for example, a metal powder, a metal braided mesh, a combination thereof, or any other suitable material for the specific application. The first capillary structure 121 and the second capillary structure 122 extend from the evaporation section 111 to the condensation section 112. The permeability of the first capillary structure 121 is greater than the permeability of the second capillary structure 122. In addition, the capillary force of the first capillary structure 121 is less than the capillary force of the second capillary structure 122.

The first capillary structure 121 within the evaporation section 111 has its thickness gradually increased from one end away from the condensation section 112 towards the other end close to the condensation section 112. That is, the first capillary structure 121 has a slope surface 1211 within the evaporation section 111. The length of the first capillary structure 121 within the evaporation section 111 depends on the size of the heat source. For example, the larger the size of the heat source is, the longer the length of the first capillary structure 121 within the evaporation section 111 will be.

Because the thickness of the first capillary structure 121 increases gradually within the evaporation section 111, and the capillary force of the first capillary structure 121 is less than the second capillary structure 122, the composite capillary structure 12 in the evaporation section 111 has a greater capillary force closer to the heat source. In this way, the thinnest part of the composite capillary structure 12 within the evaporation section 111 can have a great capillary force from the second capillary structure 122, which allows the cooling fluid to continuously flow back to the evaporation section 111 to delay or even avoid the dry burning situation. On the other side, the thickest part of the composite capillary structure 12 in the evaporation section 111 has a great permeability from the first capillary structure 121 and a great capillary force from the second capillary structure 122, which allows the cooling fluid to quickly flow back to the evaporation section 111. The composite capillary structure 12 having the gradually increased thickness in the evaporation section 111 also reduces the thermal resistance of the evaporation section 111, which, in turn, can improve the heat dissipation efficiency of the heat pipe 10.

The first capillary structure 121 within the evaporation section 111 can have a length L. The length L may be greater than or equal to 10 mm and smaller than or equal to 200 mm. Depends on the size of the heat source that will be attached to the heat pipe 10, the length L of the first capillary structure 121 within the evaporation section 111 can be adjusted accordingly to suit the specific heat source. A thickness T1 of one end of the first capillary structure 121 within the evaporation section 111 that is close to the condensation section 121 may be greater than or equal to 0.1 mm and smaller than or equal to 1 mm. More preferably, the thickness T1 may be greater than or equal to 0.1 mm and smaller than or equal to 0.5 mm. An angle R between slope surface 1211 and the inner surface 114 may be greater than or equal to 0.1 degree and smaller than or equal to 6.5 degree. More preferably, the angle R may be greater than or equal to 0.1 degree and smaller than or equal to 3.5 degree. However, the length L, thickness T1, and angle R are not limited to these. Th length L, thickness T1, and angle R can have any suitable dimensions to suit the specific application of a heat dissipating device.

In this embodiment, the first capillary structure 121 is integrated with the pipe body 11, but is not limited to this. In some embodiments, the first capillary structure 121 can be a separated entity and disposed on the pipe body 11. For example, the first capillary structure 121 can be soldered onto the pipe body 11. In this embodiment, the heat pipe 10 only includes one the second capillary structure 122, but is not limited this. In some embodiments, the number of the second capillary structure can be two or more to further improve the heat dissipation efficiency.

As shown in Fig. 2, the liquid cooling fluid can vaporize into gaseous cooling fluid after absorbs the heat from the heat source thermally coupled to the evaporation section 111. The gaseous cooling fluid can flow in the X direction through the transmission section 113 to the condensation section 112 and condenses back into the liquid cooling fluid. Due to the permeability of the first capillary structure 121 and the capillary force of the second capillary structure 122, the liquid cooling fluid can then flow back to the evaporation section 111 in the Y direction to achieve the effect of the cooling cycle.

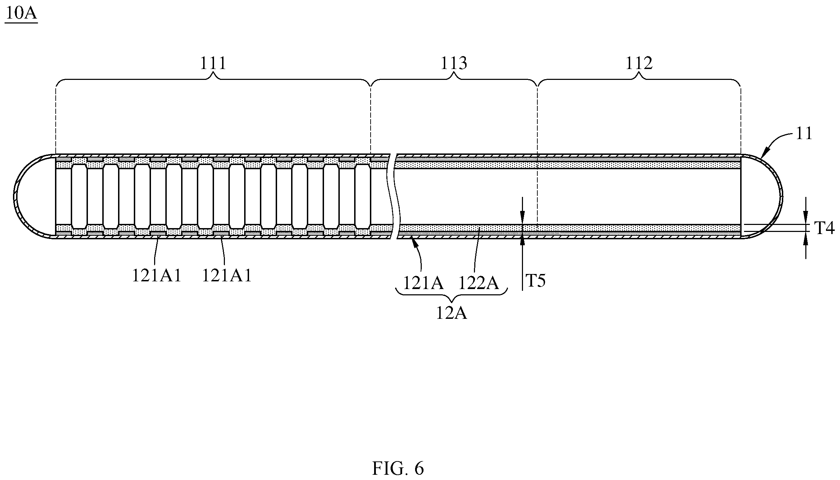

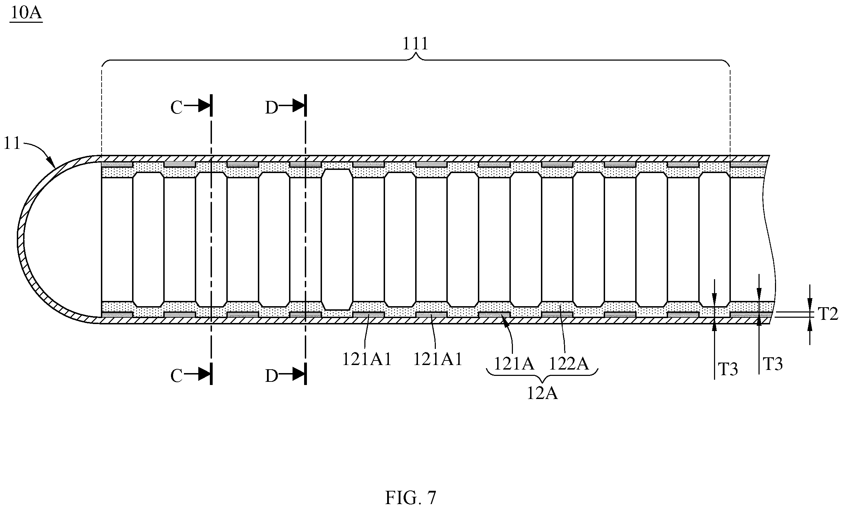

In the above embodiment, the first capillary structure 121 within the evaporation section 111 is a continuous sloped structure, but is not limited to this. The heat pipe 10A is an example. Fig. 6 illustrates a cross-sectional view of a heat pipe 10A according to aspects of the present disclosure, and Fig. 7 illustrates a partially enlarged cross-sectional view of the heat pipe 10A as shown in Fig. 6.

The heat pipe 10A is similar to the heat pipe 10 as shown in Fig. 1, a cooling fluid (not shown), for example, water, refrigerant, or alcohol such as methanol or ethanol can be used within the heat pipe 10A. The heat pipe 10A can include a pipe body 11 and a composite capillary structure 12A. The pipe body 11 can include an evaporation section 111, a condensation section 112, and a transmission section 113. The evaporation section 111 and the condensation section 112 are respectively connected to opposite ends of the transmission section 113. The evaporation section 111 can be used to thermally coupled to a heat source (not shown), such as a central processing unit (CPU) or graphics processing unit (GPU), to absorb the heat generated by the heat source.

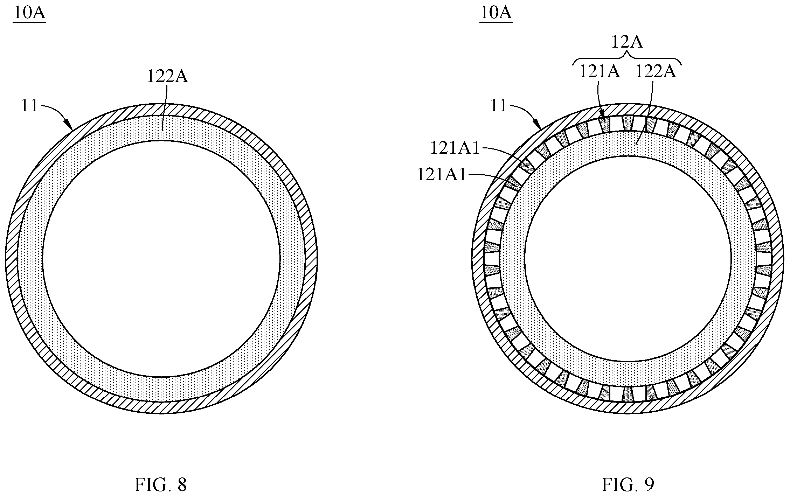

Please also refer to Fig. 8 and Fig. 9. Fig. 8 illustrates a cross-sectional view of the heat pipe 10A along the C-C cutline in Fig. 7. Fig. 9 illustrates a cross-sectional view of the heat pipe 10A along the D-D cutline in Fig. 7.

The composite capillary structure 12A includes a first capillary structure 121A and a second capillary structure 122A. The first capillary structure 121A has a grooved shape and disposed on the pipe body 11. The first capillary structure 121A can be intergraded with the pipe body 11. The second capillary structure 122A can be disposed on the first capillary structure 121A. The second capillary structure 122A can be formed using, for example, a metal powder, a metal braided mesh, a combination thereof, or any other suitable material for the specific application. The first capillary structure 121A and the second capillary structure 122 extend from the evaporation section 111 to the condensation section 112.

The first capillary structure 121A within the evaporation section 111 includes multiple spacers 121A1 that are disposed on the pipe body 11. That is, the first capillary structure 121 A within the evaporation section 111 has a non-continuous spacer structure. The second capillary structure 122A within the evaporation section 111 is disposed on the pipe body 11 and on these spacers 121A1. The thickness of the second capillary structure 122A disposed on the spacer 121A1 is smaller than the thickness of the second capillary structure 122A disposed on the pipe body 11. In this way, the thickness of the composite capillary structure 12A within the evaporation section 111 has intermittent change. In other word, the thinnest portion of the composite capillary structure 12A is where the second capillary structure 122A is disposed directly on the pipe body, and the thickest portion of the composite capillary structure 12A is where the second capillary structure 122A is disposed on the spacer 121A1 of the first capillary structure 121A. In the evaporation section 111, the second capillary structure 122A disposed on the pipe body 11 is connected with the second capillary structure 112A disposed on the spacer 121A1. The length of the first capillary structure 121A within the evaporation section 111 depends on the size of the heat source. For example, the larger the size of the heat source is, the longer the length of the first capillary structure 121A within the evaporation section 111 will be.

The evaporation section 111 of the heat pipe 10A can have a great capillary force provided by the second capillary structure 122A to delay or even avoid the dry burning situation, similar to the heat pipe 10. In addition, because portions of the second capillary structure 122A are disposed directly on the pipe body 11 in the gap between the spacers 121A1, the thermal resistance can be reduced within the evaporation section 111. At the portion where the spacers 121A is located, the composite capillary structure 12 in the evaporation section 111 can have a great permeability from the first capillary structure 121A and a great capillary force from the second capillary structure 122A, which can allow the cooling fluid to quickly flow back to the evaporation section 111. In that way, it improves the heat dissipation efficiency of the heat pipe 10A.

The first capillary structure 121A within the evaporation section 111 has a thickness T2 that can be greater than or equal to 0.01 mm and smaller than or equal to 1 mm. More preferably, the thickness T1 can be greater than or equal to 0.01 mm and smaller than or equal to 0.7 mm. The first capillary structure 121A within the transmission section 113 has a thickness that can be greater than or equal to 0.03 mm and smaller than or equal to 1 mm. The first capillary structure 121A within the transmission section 113 has a width that can be greater than or equal to 0.03 mm and smaller or equal to 0.6 mm.

The second capillary structure 122A within the evaporation section 111 can have a thickness T3 that can be greater than or equal to 0.3 mm and smaller than or equal to 10 mm, but does not limited to this. The second capillary structure 122A can have any suitable thickness as long as the thickness of the second capillary structure 122A disposed on the spacer 121A1 is the same as the thickness of the second capillary structure 122A disposed on the pipe body 11 between two neighboring spacer 121A1. The second capillary structure 122A can have a thickness T4 within the condensation section 112 and a thickness T5 within the transmission section. The thickness T4 and thickness T5 can be greater than or equal to 0.3 mm and smaller than or equal to 12 mm.

A ratio between the total length of the spacers 121A1 of the first capillary structure 121Aand the total length of the gaps between two neighboring spacers 121A1 is greater than or equal to 1/10 and smaller than or equal to 1. For example, the ratio between the total length of the spacers 121A1 of the first capillary structure 121A and the total length of the gaps between two neighboring spacers 121A1 is 1/3. Therefore, in this embodiment, the total length of the spacers 121A1 can be smaller or equal to the total length of all the gap between two neighboring spacers 121A1. However, it does not limited to this. In some embodiments, the ratio between the total length of the spacers 121A1 of the first capillary structure 121A and total length of the gaps between two neighboring spacers 121A1 is greater than or equal to 1 and smaller than or equal to 10. That is, the total length of the spacers 121A1 can be larger or equal to the total length of all the gap between two neighboring spacers 121A1.

According to the heat pipe in the abovementioned embodiments, due to the change in the total thickness of the composite capillary structure located in the evaporation section, the composite capillary structure can have great capillary force at its thinnest part provided by the second capillary structure, which can allow the cooling fluid to continuously flow back to the evaporation section to delay or even avoid the dry burning situation. In addition, the thickest part of the composite capillary structure in the evaporation section can have a great permeability from the first capillary structure and a great capillary force from the second capillary structure, which can allow the cooling fluid to quickly flow back to the evaporation section and reduce the thermal resistance of the evaporation section. In this way, it improves the heat dissipation efficiency of the heat pipe.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure.

The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

## Claims

1. A heat pipe (10, 10A), comprising:
a pipe body (11) having an evaporation section (111), a condensation section (112), and a transmission section (113), the evaporation section (111) and the condensation section (112) are respectively connected to opposite ends of the transmission section (113); and
a composite capillary structure (12, 12A) including a first capillary structure (121, 121A) and at least one second capillary structure (122, 122A), the first capillary structure (121, 121A) having a grooved shape and being disposed on an inner surface (114) of the pipe body (11), the one second capillary structure (122, 122A) being at least partially disposed on the first capillary structure (121, 121A), the first capillary structure (121, 121A) and the second capillary structure (122, 122A) extending from the evaporation section (111) to the condensation section (112), wherein
the composite capillary structure (12, 12A) has a variable thickness within the evaporation section (111).

2. The heat pipe (10) of claim 1, wherein a thickness of the first capillary structure (121) within the evaporation section (111) is gradually increased from one end away from the condensation section (112) to one end close to the condensation section (112), so that the variable thickness of the composite capillary structure (12) varies within the evaporation section (111).

3. The heat pipe (10) of claim 2, wherein the first capillary structure (121) within the evaporation section (111) has a length (L) greater than or equal to 10 mm and smaller than or equal to 200 mm.

4. The heat pipe (10) of claim 2 or 3, wherein the thickness (T1) of the first capillary structure (121) within the evaporation section (111) and at one end close to the condensation section (112) is greater than or equal to 0.1 mm and smaller than or equal to 1 mm.

5. The heat pipe (10) of claim 4, wherein the thickness (T1) of the first capillary structure (121) within the evaporation section (111) and at one end close to the condensation section (112) is greater than or equal to 0.1 mm and smaller than or equal to 0.5 mm.

6. The heat pipe (10) of one of claims 2 to 4, wherein the first capillary structure (121) within the evaporation section (111) has a slope surface (1211), where an angle (R) between the slope surface (1211) and the inner surface (114) of the pipe body (11) is greater than or equal to 0.1 degree and smaller than or equal to 6.5 degree.

7. The heat pipe (10) of claim 6, wherein the angle (R) between the slope surface (1211) and the inner surface (114) of the pipe body (11) is greater than or equal to 0.1 degree and smaller than or equal to 3.5 degree.

8. The heat pipe (10A) of claim 1, wherein the first capillary structure (121A) within the evaporation section (111) has a plurality of spacers (121A1) disposed on the inner surface (114) of the pipe body (11), the at least one second capillary structure (122A) within the evaporation section (111) is disposed on the plurality of spacers (121A1) and the pipe body (11) so that the variable thickness of the composite capillary structure (12A) within the evaporation section (111) has intermittent changes.

9. The heat pipe (10A) of claim 8, wherein the at least one second capillary structure (122A) disposed on the plurality of spacers (121A1) has a first thickness and the at least one second capillary structure (122A) disposed on the pipe body (11) has a second thickness, where the first thickness is smaller than the second thickness.

10. The heat pipe (10A) of claim 9, wherein the first capillary structure (121A) has a thickness that is greater than or equal to 0.01 mm and smaller than or equal to 1 mm.

11. The heat pipe (10A) of claim 10, wherein the thickness of the first capillary structure (121A) is greater than or equal to 0.01 mm and smaller than or equal to 0.7 mm.

12. The heat pipe (10A) of claim 9, wherein the first thickness or the second thickness of the at least one second capillary structure (122A) is greater than or equal to 0.3 mm and smaller than or equal to 10 mm.

13. The heat pipe (10A) of claim 9, wherein a ratio between a total length of the plurality of spacers (121A1) and a total length of gaps between two adjacent spacers (121A1) is greater than or equal to 1/10 and smaller than or equal to 1.

14. The heat pipe (10A) of claim 13, wherein the ratio between the total length of the plurality of spacers (121A1) and the total length of gaps between two adjacent spacers (121A1) is 1/3.

15. The heat pipe (10A) of claim 9, wherein a ratio between a total length of the plurality of spacers (121A1) and a total length of gaps between two adjacent spacers (121A1) is greater than or equal to 1 and smaller than or equal to 10.

16. The heat pipe (10, 10A) of claim 1, wherein the at least one second capillary structure (122, 122A) is metal powder, metal braided mesh, or a combination thereof.

17. The heat pipe (10, 10A) of claim 1, wherein the at least one second capillary structure (122, 122A) within the evaporation section (111) has a variable thickness.
